# EUROPEAN PATENT APPLICATION

(11) **EP 4 113 584 A1**
(43) Date of publication of application: **04.01.2023**
(21) Application number: 21183532.7
(22) Date of filing: 02.07.2021
(51) Int. Cl.: H01L 21/67

(54) **SYSTEM AND METHOD FOR A SURFACE TREATMENT OF A SUBSTRATE WITH A LIQUID**

(71) Applicant: Semsysco GmbH, 5020 Salzburg (AT)
(72) Inventor: HOFER, Georg, 8862 Stadl-Predlitz (AT); GLEISSNER, Andreas, 9873 Döbriach (AT)
(74) Representative: Maiwald GmbH

(57) **Abstract**

The disclosure relates to a system (17) for a surface treatment of a substrate (1) with a liquid, comprising: a first substrate holder (18), a second substrate holder (19), a liquid dispensing unit (21), a treatment chamber (20), and control unit (22), wherein the first substrate holder (18) is configured to hold the substrate (1), wherein the first substrate holder (18) is moveable in the treatment chamber (20) and configured to hand the substrate (1) over to the second substrate holder (19), wherein the second substrate holder (19) is rotatable and configured to hold the substrate (1) during a rotation of the substrate (1) in and relative to the treatment chamber (20), wherein the liquid dispensing unit (21) is moveable relative to the second substrate holder (19) and configured to dispense the liquid onto the substrate (1), and wherein the control unit (22) is configured to control a rotational speed of the substrate (1), a position of the liquid dispensing unit (21) and/or a dispense rate of the liquid. Further, the disclosure also relates to a method (100) for a surface treatment of a substrate (1) with a liquid, and to a computer program element for a system (17) for a surface treatment of a substrate (1) with a liquid.

## Description

### Technical Field

The disclosure relates to a system for a surface treatment of a substrate with a liquid, a method for a surface treatment of a substrate with a liquid and a computer program element for a system for a surface treatment of a substrate with a liquid.

### Background

In semiconductor processing, substrates, such as wafers, are exposed to many material deposition or growth steps to produce an electronic device. During these steps, materials are not only deposited on one side of the substrate, which is usually a front side of the substrate, but also on other sides, usually on the back side of the substrate, as well as on areas around the edges of the substrate. The material deposition or grown layers on the back side and around the edges of the substrate are mostly unwanted and have to be removed without damaging or removing any material deposition and/or grown layers on the front side of the substrate, particularly the material deposition and/or grown layers within a critical area of the front side of the substrate. The critical area is defined as the area, which is configured to be used as part of the electronic device, e.g., a sensor and the like.

Removing the material deposition and/or grown layers from the back side and around the edges of the substrate is usually performed by a so-called Backside-Bevel-Etch/Clean-process, which can be also simply a so-called Backside-Bevel-Clean-process, in case only contaminations, such as particles, need to be removed.

During the Backside-Bevel-Etch/Clean-process, the material deposition and/or grown layers on the back side and around the edges of the substrate as well as within a so-called "edge exclusion zone", which at least partly extends on the front side of the substrate, are removed. The edge exclusion zone is an area of the substrate not being used or not capable of being used to produce a functional electronic device.

In common fabrication environments, many different technologies for producing electronic devices are processed in parallel through an established and qualified processing line comprising processing systems, which are hereafter referred to as equipment, which can be easily and quickly adjusted to the specific requirements of each of the various technologies.

The edge exclusion zone is formed by removing the material deposition and/or grown layers in a predefined area on the front side of the substrate. The forming of the edge exclusion zone is a highly critical part of the Backside-Bevel-Etch/Clean-process as it needs to be reproducible for at least several wafers of the same technology, and additionally, uniformly and substantially straight cornered all around the substrate to achieve the technology requirements of the resulting electronic devices. In particular, the term "straight cornered" may mean "cornered at a specific radius" or "edged off'.

In the prior art, a change in the requirements on the edge exclusion zone causes significant changes to the equipment resulting in very high adapting efforts, e.g. due to the need of exchanging critical parts, and/or cannot due to the inability to achieve the required preciseness to adequately produce the edge exclusion zone without changing the equipment. Therefore, the adjustment of the equipment to the changing technology requirements either causes significant additional costs and/or time and/or is restricted with regard to the achievable preciseness for the edge exclusion zone.

### Summary disclosure

Hence, there may be a need to provide an improved system for a surface treatment of a substrate with a liquid, which allows reducing the adjustment effort while providing the required preciseness for producing the edge exclusion zone.

This problem is solved by the subject-matters of the independent claims, wherein further embodiments are incorporated in the dependent claims. It should be noted that the aspects of the invention described in the following apply also to a system for a surface treatment of a substrate with a liquid, a method for a surface treatment of a substrate with a liquid and a computer program element for a system for a surface treatment of a substrate with a liquid.

According to the present disclosure, a system for a surface treatment of a substrate with a liquid is presented. The system comprises a first substrate holder, a second substrate holder, a liquid dispensing unit, a treatment chamber, and a control unit. The first substrate holder is configured to hold the substrate, is moveable in the treatment chamber and configured to hand the substrate over to the second substrate holder. The second substrate holder is rotatable and configured to hold the substrate during a rotation of the substrate in and relative to the treatment chamber. The liquid dispensing unit is moveable relative to the second substrate holder and configured to dispense the liquid onto the substrate. The control unit is configured to control a rotational speed of the substrate, a position of the liquid dispensing unit and/or a dispense rate of the liquid.

Such system may allow performing the surface treatment of a substrate with a liquid completely by controlling process parameters via software control only. This results in a highly flexible system, which is able to adjust a process for the surface treatment of a substrate to different technology requirements, especially to the changes of the edge exclusion zone, only by changing process parameters and without any hardware changes, that means, without any physical changes of the equipment. In particular, the system permits a highly efficient and effective Backside-Bevel-Etch/Clean process for all the different technology requirements in a modern, highly productivity fabrication facility.

Furthermore, the system may allow achieving different edge exclusion zones with high preciseness, preventing imperfections and/or defects like pin-marks on the edge exclusion zone, or a non-uniform edge exclusion zone around the substrate perimeter due to a non-centered substrate. Additionally, or alternatively, slipping, particularly uncontrolled slipping, of the substrate resulting in a non-exact process parameter control may be prevented by the system.

Further, the system may allow adjusting the Backside-Bevel-Etch/Clean-process so fast that a changing of the Backside-Bevel-Etch/Clean-process may be possible from substrate to substrate only by adjusting process parameters being selectable through the control unit.

The first substrate holder and the second substrate holder may provide a dual-substrate holding and/or processing scheme, which allows achieving high quality process results and reducing or eliminating the risk of pin marks on the edge exclusion zone. Further, by providing the dual-substrate holding, a pre-alignment station may be no longer required resulting in a significantly reduced footprint of the equipment, saving of expensive clean room space, a significant reduction in the handling complexity and handling time as well as in an improved substrate throughput. Overall, a significant simplification in the complexity as well as a significant reduction of the Cost of Ownership for the equipment can be achieved.

The surface treatment of the substrate with a liquid may be preferably performed with a wet chemical process of substrates. The wet chemical process may further be a wet chemical etching process and/or a wet chemical cleaning process. In a wet chemical process, the surfaces or parts of the surfaces of the substrate may be etched or cleaned with various individual process liquids, like acids, bases, oxidizers, etc., and/or with mixtures thereof. Wet chemical processes may provide a high chemical selectivity and may be easily executable and scalable to various types of substrates of various sizes. Additionally, wet chemical processes may allow a low cost of operation.

Preferably, the system may be a so-called single-wafer processing system, configured to process only one substrate at a time. Further, the system may be able to perform the processes sequentially or simultaneously, which provides a significantly improved process flexibility and process control.

The substrate to be treated may be a silicon wafer or the like, having a diameter or diagonal of up to 300 mm or up to 450 mm or more.

The liquid dispensing unit may be configured to be able to dispense diverse liquids as well as other fluids, e.g., gases.

The system may be constructed from a chemical compatible material, such as stainless steel, aluminum, titanium, or plastics, such as polyether ether ketone (PEEK), polyethylene terephthalate (PET), polyvinyl chloride (PVC), polypropylene (PP), or the like. In this way, the system may provide a sufficient rigidity and stability. The material may be additionally coated with a chemical compatible polymer, e.g. perfluoroalkoxy alkanes (PFA), ethylene chlorotrifluoroethylene copolymer (ECTFE), polytetrafluoroethylene (PTFE), ethylene tetrafluoroethylene (ETFE), fluorinated ethylene propylene (FEP), and the like.

In an embodiment, the control unit may be configured to control the rotational speed of the substrate, the position of the liquid dispensing unit and/or the dispense rate of the liquid to provide lamella oscillations of the liquid dispensed onto the rotating substrate.

Lamella oscillations describe a phenomenon that depending on the dispense rate of the liquid, the position of the liquid dispensing unit and the rotational speed of the substrate, a certain oscillation of a lamella formation and its disappearance occur. Further, a surface energy level of the substrate may impact the lamella oscillations and therefore, the optimal process parameters, e.g., the degree of hydrophilicity and/or hydrophobicity, contact angle etc.

By means of the lamella oscillations, it may be able to choose the correct software-controlled parameter setting for each incoming wafer to be processed correctly without the need of any physical changes to the system. Thereby, time-consuming re-adjustments of the system, re-testing and re-qualification on a physically changed system may be prevented.

In other words, the lamella oscillations may be used and/or tuned to achieve high process flexibility to tune the edge exclusion zone through process parameter control only. Furthermore, the lamella oscillations may allow achieving high re-producibility from wafer to wafer having the same technology requirements, as well as flexibility in-between wafers of varying technology requirements.

In an embodiment, the control of the position of the liquid dispensing unit may be a control of an oscillating movement of at least a part of the liquid dispensing unit between at least two position points.

Such an oscillating movement may support the creation or occurrence of a lamella formation as desired for achieving good and precise process results.

In an embodiment, the liquid dispensing unit may comprise at least one of a first liquid dispensing element arranged at the first substrate holder, a second liquid dispensing element arranged inside the second substrate holder, and a third liquid dispensing element arranged at the second substrate holder. Further, at least one liquid dispensing element may be configured to dispense a liquid different from another liquid being dispensed by another liquid dispensing element of the liquid dispensing unit. Additionally the at least one liquid dispensing element may be configured to dispense other fluids, e.g. gases.

The first liquid dispensing element being arranged at the first substrate holder may be configured to provide a gas flow or to dispense liquid to a surface, preferably the front side, of the substrate. The second liquid dispensing element being arranged inside the second substrate holder may be configured to dispense liquid to another surface, preferably the back side, of the substrate, particularly for cleaning this surface of the substrate. The third liquid dispensing element being arranged at the second substrate holder may be configured to dispense liquid for etching and/or cleaning the bevels or edges of the substrate.

Providing the three separate liquid dispensing elements may allow performing the Backside-Bevel-Etch/Clean-process simultaneously for the back side and the bevel, or sequentially, wherein first the back side and then the bevel may be processed, or vice versa. This may provide a high flexibility in performing the Backside-Bevel-Etch/Clean-process.

In an embodiment, the first substrate holder may comprise fingers, which are moveable into a closed position to hold the substrate and into an open position to receive or release the substrate.

The first substrate holder may be configured to be rotatable with the fingers in the open position as well as in the closed position. By rotating the first substrate holder with the fingers in the open position, pin-marks on the substrate may be prevented. Further, the fingers may center the substrate, particularly relative to the second substrate holder, and/or move the substrate into the treatment chamber. The first substrate holder comprising fingers may be also called finger-rotor.

In an embodiment, the second substrate holder may be a vacuum holder configured to hold the substrate by means of suction.

The second substrate holder being a vacuum holder may hold the substrate sufficiently strong in a fixed and centered position by means of providing a sufficiently strong suction effect, thereby avoiding slipping, particularly uncontrolled slipping, of the substrate.

In an embodiment, the liquid dispensing unit may comprise at least a liquid dispensing arm.

The at least one liquid dispensing arm may also be referred to as media arm. The liquid dispensing arm may be configured to continuously oscillate between at least two pre-determined positions during processing the substrate.

In an embodiment, the system may further comprise a drying unit to dry the substrate.

After the backside-etch and/or the bevel-etch, the substrate may be at least partly rinsed, e.g. by dispensing a rinsing liquid onto the substrate with at least one of the liquid dispensing elements. After the rinsing process, the substrate may undergo a drying process before being discharged from the treatment chamber.

According to the present disclosure, also a method for a surface treatment of a substrate with a liquid is presented. The method comprises the following steps, not necessarily in the presented order:
- moving a first substrate holder holding a substrate in a treatment chamber,
- handling the substrate over from the first substrate holder to a rotatable second substrate holder,
- rotating the substrate held by the second substrate holder in and relative to the treatment chamber,
- dispensing a liquid onto the rotating substrate by means of a liquid dispensing unit which is moveable relative to the second substrate holder, and
- controlling a rotational speed of the substrate, a position of the liquid dispensing unit and/or a dispense rate of the liquid.

According to this method, the substrate may be preferably processed at an area around an edge of the substrate, wherein the substrate may be held in a so-called face-up configuration. The first substrate holder may center the substrate by picking up the substrate. Optionally, the substrate may be exposed to an initial process being carried out before the substrate may be moved into the treatment chamber, e.g. backside etching.

Handling the substrate over from the first substrate holder to the second substrate holder may preferably be performed without flipping the substrate allowing to process the substrate in the face-up configuration.

The rotation speed, with which the substrate held by the second substrate holder may be rotated, may depend on the individual technology requirements to achieve the required edge exclusion zone with the required high quality.

During the liquid dispense onto the rotating substrate, the front side of the substrate may be physically protected, e.g., by maintaining the first substrate holder in a very close position to the front side of the substrate, preferably in a distance of equal to or less than 1 mm.

In an embodiment, the rotational speed of the substrate, the position of the liquid dispensing unit and/or the dispense rate of the liquid may be controlled to provide lamella oscillations of the liquid dispensed onto the rotating substrate.

Lamella oscillation may support achieving good and precise results with regard to the edge exclusion zone. By means of the lamella oscillations, it may be able to choose the correct software-controlled parameter settings for each incoming wafer to be processed correctly without the need of any physical changes to the system. Thereby, time-consuming re-adjustments of the system, re-testing and re-qualification on a physically changed system may be prevented.

In other words, the lamella oscillation may be used and/or tuned to achieve high process flexibility to tune the edge exclusion zone through process parameter control only and to achieve high re-producibility from wafer to wafer for wafers with the same technology requirements and to achieve highly accurate flexibility for wafers with different technology requirements.

In another embodiment, the liquid dispensing unit may comprise a first liquid dispensing element arranged at the first substrate holder.

The first liquid dispensing element may be mostly used to provide a gas flow for protecting a surface of the substrate at least partly from liquid spilling coming from other liquid dispensing elements. Further, the first liquid dispensing element may also be used to dispense a rinsing and/or cleaning liquid to rinse and/or clean the substrate.

According to a further embodiment, the method may further comprise the following steps, not necessarily in the presented order:
- handling the substrate back to the first substrate holder,
- dispensing liquid by means of the liquid dispensing unit onto an area of the substrate previously covered by the second substrate holder, and
- controlling a rotational speed of the substrate, a position of the liquid dispensing unit and/or a dispense rate of the liquid.

Thus, a surface, particularly the back side of the substrate, may be processed to remove any material depositions and/or material layers. By controlling the rotational speed of the substrate, a position of the liquid dispensing unit and/or a dispense rate of the liquid, it may be possible to adapt the process parameters only by software control to the required technology standards.

In an embodiment, the method may further comprise rotating of the substrate held by the first substrate holder. In an embodiment, the liquid dispensing unit may comprise a second liquid dispensing element arranged inside the second substrate holder.

In case, the substrate may be held by the first substrate holder and rotated with the first substrate holder, the second liquid dispensing element may be used to dispense a liquid, such as an etching liquid or a cleaning liquid, onto the surface of the substrate facing the second liquid dispensing element.

In an embodiment, the surface treatment may be an etching and/or cleaning by means of an etching liquid and/or a cleaning liquid as the liquid dispensed onto the rotating substrate.

Thus, the substrate may be etched and/or cleaned without the need of changing the treatment chamber.

According to a further embodiment, the method may further comprise a rinsing to rinse the substrate and/or a drying to dry the substrate.

In an embodiment, the substrate may comprise a front side with a functional surface, a back side opposite to the front side, and an edge between the front side and the back side. The rotational speed of the substrate, the position of the liquid dispensing unit and/or the dispense rate of the liquid may be controlled to treat the edge of the substrate, an edge exclusion zone at the front side of the substrate and/or the back side of the substrate.

The edge of the substrate, the edge exclusion zone at the front side of the substrate and/or the back side of the substrate may be parts of the substrate which cannot contribute any function to the electronic device being formed by material depositions and/or material layers being built at least partly on the front side of the substrate. In some cases, the material depositions and/or material layers on the edge, the edge exclusion zone and/or the backside of the substrate may be even detrimental for the function of the electronic device. Therefore, the material depositions and/or material layers on the areas, which are without any function for the electronic device, may be removed by etching and/or cleaning.

In an embodiment, the liquid dispensing unit may comprise a third liquid dispensing element arranged at the second substrate holder, and may be preferably arm-shaped.

The third liquid dispensing element may also be referred to as media arm. The media arm may be configured to continuously oscillate between at least two pre-determined positions during processing the substrate and configured to dispense liquid at least onto an edge of the rotating substrate.

In another embodiment, the edge, the edge exclusion zone and/or the back side may be treated simultaneously or sequentially. This allows a high flexibility in performing the surface treatment process.

In an embodiment, the controlled position of the liquid dispensing unit may comprise a distance between the liquid dispensing unit and the edge of the substrate. This allows the formation of lamella oscillations, which, when formed correctly, supports achieving high quality results on the edge exclusion zone.

In an embodiment, the rotational speed of the substrate, the position of the liquid dispensing unit and/or the dispense rate of the liquid may be controlled to treat the edge exclusion zone in a width between 0.2 and 12 mm, preferably 0.5 to 9 mm.

According to a further embodiment, the method may further comprise a protection of an area not to be treated on the front side of the substrate by means of the first substrate holder and/or a gas flow provided by the first liquid dispensing element.

Thus, a so-called active area may be protected from chemical spilling during etching and/or cleaning of the back side and/or edge of the substrate. The active area is an area on the front side of the substrate, which is part of the electronic device.

In a further embodiment, the method may further comprise a rotational centering of the substrate relative to the second substrate holder by means of the first substrate holder.

This may provide a fail-safe rotation centering of the substrate, thereby enabling to form a substantially homogeneous and substantially uniform edge exclusion zone all around the substrate.

In an embodiment, the method may further comprise a rotation of the first substrate holder during rotating the substrate in the second substrate holder. Thus, the first substrate holder may allow protecting the surface of the substrate facing towards the first substrate holder from chemical spilling.

In another embodiment, the handling of the substrate between the first substrate holder and the second substrate holder may be done at a rotational speed in a range of 0-700 rpm, particularly in a range of 20-600 rpm.

In an embodiment, the orientation of the substrate relative to the treatment chamber, preferably front side up, may be maintained throughout the method for surface treatment. By eliminating the need to turn the wafer during the surface treatment, the complexity of the equipment may be significantly reduced. Furthermore, an alignment with the liquid dispense elements may be significantly simplified as well as a risk for damaging the substrate may be reduced. Further, the costs for systems able to perform the described method may be significantly reduced. Thus, the processing of the substrate may be significantly simplified and reduced in cost.

In an embodiment, the control to provide lamella oscillations, in particular a software control, may be the only adaption to different surface treatment requirements, in particular without tool change.

Thus, a software control may enable a completely process parameter controlled, high flexible and improved Backside-Bevel-Etch/Clean-process without the need of time- and/or cost-intensive tool changes.

According to the present disclosure, also a computer program element for a system for a surface treatment of a substrate with a liquid is presented. The computer program, when being executed by a processing element, is adapted to perform the steps of one of the method embodiments as described above.

It shall be understood that the system, the method, and the computer program element according to the independent claims have similar and/or identical preferred embodiments, in particular, as defined in the dependent claims. Further, it shall be understood that a preferred embodiment of the disclosure can also be any combination of the dependent claims with the respective independent claim.

These and other aspects of the present disclosure will become apparent from and be elucidated with reference to the embodiments described hereinafter.

### Brief description of the drawings

Exemplary embodiments of the invention will be described in the following with reference to the accompanying drawing:
- Figures 1a and 1b: show schematically and exemplarily a substrate before (a) and after (b) a Backside-Bevel-Etch/Clean-processing according to the disclosure;
- Figures 2a and 2b: show schematically and exemplarily two substrate geometries according to the SEMI standard;
- Figure 3: shows schematically and exemplarily an edge exclusion zone build according to the disclosure;
- Figure 4: shows schematically and exemplarily a system for a surface treatment of a substrate with a liquid according to the disclosure in a load/unload position;
- Figure 5: shows schematically and exemplarily a system for a surface treatment of a substrate with a liquid according to the disclosure in a processing configuration for bevel-etch;
- Figure 6: shows schematically and exemplarily a system for a surface treatment of a substrate with a liquid according to the disclosure in a processing configuration for backside-etch and -clean;
- Figures 7a and 7b: shows schematically and exemplarily lamella oscillations according to the disclosure, wherein Figure 7a shows a desired lamella formation and Figure 7b shows an undesired state of lamella breaking off; and
- Figure 8: shows schematically and exemplarily a method for a surface treatment of a substrate with a liquid according to the disclosure.

### Detailed description of embodiments

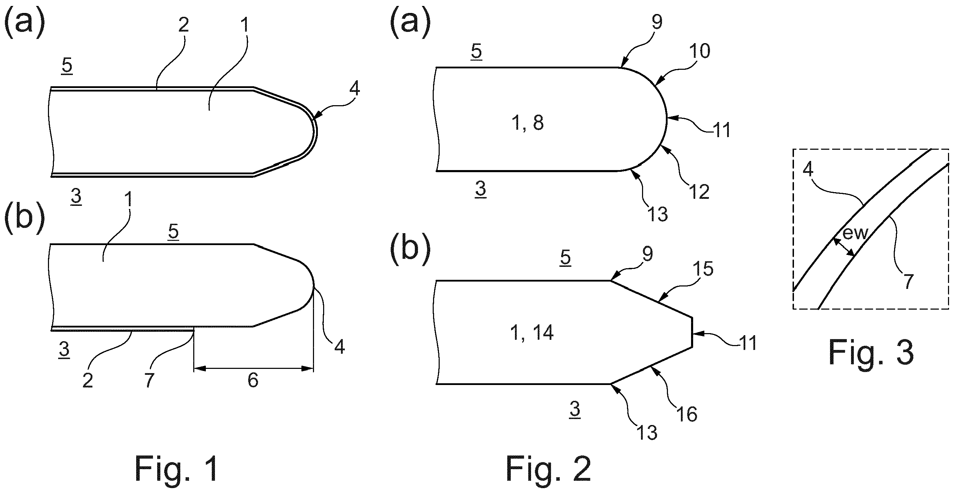

Figure 1a shows schematically and exemplarily a substrate 1 having a material layer 2 deposited all over the entire surfaces of the substrate 1, namely a front side 3, an edge 4, and a back side 5. The substrate 1 may be a substantially round silicon wafer having a diameter of about 300 mm or more. Additionally, substrates with a diameter of less than 300 mm can also be applied. The material layer 2 is configured to build an electronic device only on the front side 3 of the substrate 1. The material layer 2 on the edge 4 and the back side 5 is not required for the electronic device, and in some cases, the material layer 2 on the back side 5 and the edge 4 may be even detrimental to the function of the electronic device. Therefore, the part of the material layer 2, which is not required for building the electronic device, needs to be removed.

Figure 1b shows schematically and exemplarily the substrate 1 having the material layer 2 removed from all parts of the substrate 1, on which the material layer 2 does not contribute to a function to the electronic device. A process to remove the material layer 2 from all part of the substrate 1, on which the material layer 2 does not comprise a functional contribution, is called a Backside-Bevel-Etch/Clean process.

Thus, in Figure 1b, the material layer 2 has been removed from the back side 5, the edge 4 and from a small radial part close to the edge 4 on the front side 3. This radial part is called an edge exclusion zone 6. The edge exclusion zone 6 is an area on the front side 3 and part of the edge 4, which cannot be used to produce functional electronic devices. The edge exclusion zone 6 needs to be achieved exactly conforming to the technology requirements of the electronic device being build and has to be reproducible from wafer to wafer of the same technology. The edge exclusion zone 6 may extend in the radial direction from 0 mm to 8 mm, preferably from 0 mm to 5 mm. A transition from the remaining material layer 2 on the front side 3 of the substrate 1 and the edge exclusion zone 6 is formed by a new material edge 7.

Figures 2a and 2b show schematically and exemplarily two substrate geometries according to the Semiconductor Equipment and Materials International (SEMI) standard, which are commonly used for building electronic devices. Figure 2a shows a so-called "blunt nosed wafer" 8 being a substrate 1 formed as a substantially round wafer having a rounded edge 4. The blunt nosed wafer 8 comprises a smooth transition from a flat wafer surface, namely the front side 3 and the back side 5, to the edge 4. The rounded edge 4 may be divided into five sections: a transition area 13 from the front side 3 to the edge 4, a front side rounded region 12, a crown or apex 11, a back side rounded region 10, and a transition area 9 from the back side 5 to the edge 4.

Figure 2b shows a so-called "bullet shaped wafer" 14 being a substrate 1 formed as a substantially round wafer having a beveled edge 4. The beveled edge 4 may be formed by a so-called "bevel-grinding-process" having an angle of substantially 22 degrees to the main surfaces of the substrate 1, namely the front side 3 and the back side 5. The beveled edge 4 may be divided into five sections: the transition area 13 from the front side 3 to the edge 4, a front side bevel region 16, the crown or apex 11, a back side bevel region 15, and the transition area 9 from the back side 5 to the edge 4.

Figure 3 shows schematically and exemplarily the edge exclusion zone 6 being build according to the disclosure. After the Backside-Bevel-Etch/Clean-process, the front side 3 of the substrate 1 comprises the edge exclusion zone 6 having an extension width "ew" in the radial direction. The edge exclusion zone 6 is formed all around the substrate 1 having the new material edge 7 as a smooth, continuous formed transition from the edge exclusion zone 6 to the material layer 2 on the front side 3.

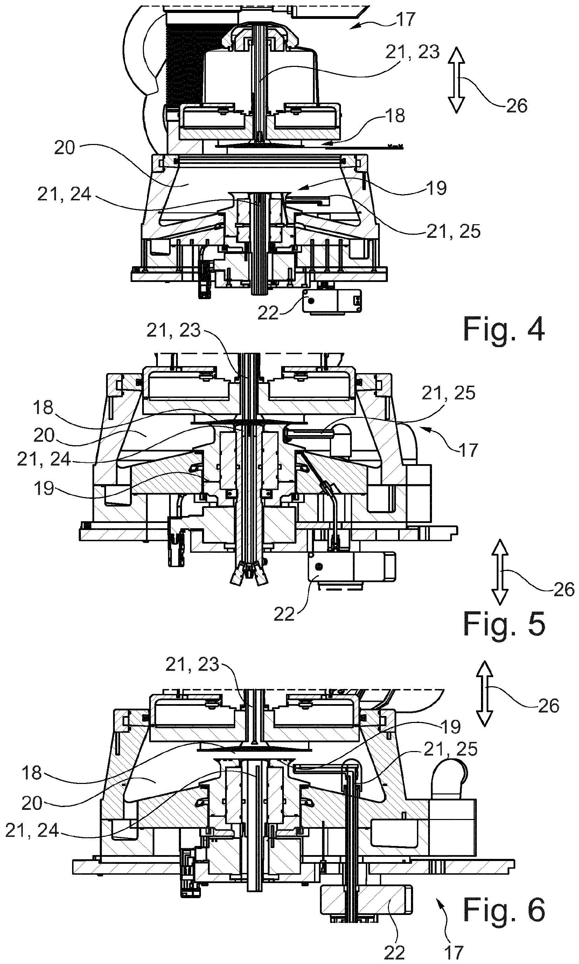

Figures 4 to 6 show schematically and exemplarily a system 17 for a surface treatment of the substrate 1 with a liquid according to the disclosure, in different configurations, wherein Figure 4 shows a load/unload configuration, Figure 5 shows a processing configuration for bevel-etch, and Figure 6 shows a processing configuration for backside-etch and -clean.

The system 17 is configured as a so-called single-wafer processing system for only processing one substrate 1 at a time. The substrate 1 to be processed in the system 17 may be a substantially round silicon wafer having a diameter up to 300 mm or more. The system 17 comprises a first substrate holder 18 and a second substrate holder 19. The first substrate holder 18 is configured to hold the substrate 1 and is movable in a treatment chamber 20, particularly in an up-an-down-direction 26. Further, the first substrate holder 18 may be rotatable inside the treatment chamber 20 and is configured to hand the substrate 1 over to the second substrate holder 19 inside the treatment chamber 20. The second substrate holder 19 is configured to be stationary, but rotatable inside the treatment chamber 20 and further configured to hold the substrate 1 during a rotation of the substrate 1 inside and relative to the treatment chamber 20.

Further, the system 17 may be configured to process the substrate 1 in a face-up configuration (see also Figure 5). This means that the front side 3 of the substrate 1 is directed upwards, thus it is positioned towards the first substrate holder 18 and the back side 5 of the substrate 1 is directed towards the second substrate holder 19.

The system 17 further comprises a liquid dispensing unit 21 for dispensing a liquid onto the substrate 1 inside the treatment chamber 20 and a control unit 22. The control unit 22 is configured to control a rotational speed of the substrate 1, a position of the liquid dispensing unit 21 and/or a dispense rate of the liquid being dispensed by the liquid dispensing unit 21. The liquid dispensing unit 21 is movable relative to the second substrate holder 19. Further, according to the exemplary embodiments shown in the Figures 4 to 6, the liquid dispensing unit 21 comprises a first liquid dispensing element 23, a second liquid dispensing element 24 and a third liquid dispensing element 25.

The first liquid dispensing element 23 is arranged at the first substrate holder 18 and is configured to dispense a liquid or a gas flow onto an upward directed surface of the substrate 1, usually the front side 3 of the substrate 1. The second liquid dispensing element 24 is arranged inside the second substrate holder 19 and configured to dispense a liquid onto a downward directed surface of the substrate 1 for etching and/or cleaning of this surface, usually the back side 5 of the substrate 1. The third liquid dispensing element 25 is arranged at the second substrate holder 19, preferably laterally below the second substrate holder 19, and is configured to dispense a liquid onto the edge 4 of the substrate 1 for etching and/or cleaning the edge 4 of the substrate 1. In a preferred embodiment, the third liquid dispensing element 25 is a liquid dispensing arm, the position of which being controllable by the control unit 22.

An exemplary processing sequence may be as follows: The substrate 1 is handled over to the first substrate holder 18, e.g., by a robot arm (not shown). The first substrate holder 18 comprises at least two fingers (not shown), which are movable into a closed position to hold the substrate 1, and into an open position to receive or release the substrate 1. Therefore, the first substrate holder 18 may also be referred to as finger-rotor. By taking over the substrate 1 from the robot arm, the first substrate holder 18 automatically centers the substrate 1 and moves the substrate 1 into the treatment chamber 20 (see Figure 4). Inside the treatment chamber 20, the first substrate holder 28 handles the substrate 1 over to the second substrate holder 19 without the need of flipping the substrate 1 (see Figure 5). The handling of the substrate 1 between the first substrate holder 18 and the second substrate holder 19 may be performed at a rotational speed in a range of 0-700 rpm, and particularly in a range of 20-600 rpm.

The second substrate holder 19 is configured to hold the substrate 1 by means of suction and thus, may also be referred to as vacuum-holder. The second substrate holder 19 is able to create a sufficiently strong suction action to fixedly hold the substrate 1 in a centered position and to avoid any undesired and/or uncontrolled slip of the substrate 1. Figure 5 exemplarily shows the processing configuration of the system 17 after the substrate 1 has been handled over from the first substrate holder 18 to the second substrate holder 19. In this position, the etching and/or cleaning of the edge 4 of the substrate 1, the so-called bevel-etch-process, is carried out. The process parameters are selected by the control unit 22 in accordance with the requirements of the selected technology to achieve the edge exclusion zone 6 fulfilling the requirements regarding preciseness of the radial extension width ew and quality of the edge exclusion zone 6.

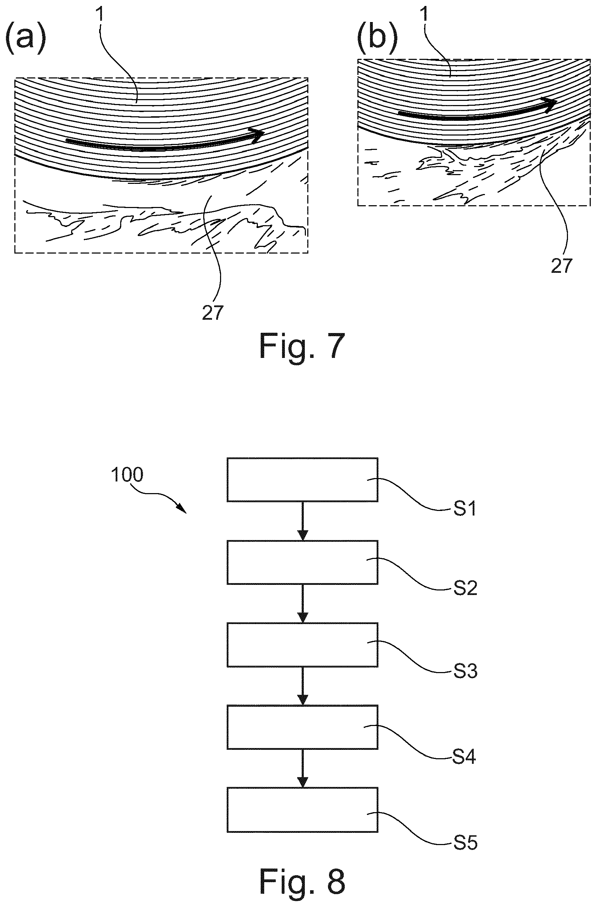

The main process parameters to be controlled by the control unit 22 to achieve the required edge exclusion zone 6, are a rotation speed (rotation per minute) of the substrate 1, the position of the liquid dispensing unit 21, particularly the position of the third liquid dispensing element 25 relative to the edge 4 of the substrate 1, and at least one liquid dispensing rate through the third liquid dispensing element 25. Controlling the position of the liquid dispensing unit 21 comprises a control of an oscillating movement of at least a part of the liquid dispensing unit 21 between at least two positions. The control unit 22 is configured to control at least these parameters such that so-called lamella oscillations (see also Figures 7a and 7b), are provided. Thus, the system 17 allows achieving an edge exclusion zone 6 with an extension width ew between 0.2 mm and 12 mm, preferably 0.5 mm to 9 mm only by controlling software process parameters.

During the bevel-etch-process, the substrate 1 is rotated by the second substrate holder 19 with a predetermined rotational speed being controlled by the control unit 22, and at least the third liquid dispensing element 25 dispenses a liquid onto a region of the edge 4. The liquid may be a chemical solution, such as an etching liquid, configured to remove material depositions and/or material layers 2 (see Figure 1) from the edge 4 area. The control unit 22 controls the position of the liquid dispensing unit 21 by controlling an oscillating movement of at least a part of the liquid dispensing unit 21 between at least two positions and/or controlling a distance between the liquid dispensing unit 21 and the edge 4.

The front side 3 of the substrate 1 is physically protected to prevent spilling of the liquid being dispensed by the third liquid element 25 into an active area of the substrate 1, the active area being the functional area of the electronic device. Preferably, the front side 3 of the substrate 1 is protected by maintaining the first substrate holder 18 in a very close position, e.g. equal to or less than 1 mm, to the front side 3 of the substrate 1.

Additionally, the first liquid dispensing element 23 dispenses a gas flow, e.g. a nitrogen gas flow, to create a gas flow curtain between the first substrate holder 18 and the front side 3 of the substrate 1. The physical protection through the first substrate holder 18 as well as the gas flow are controllably adjusted by the control unit 22 such that the required edge exclusion zone 6, particularly the part of the edge exclusion zone 6 extending onto the front side 3 of the substrate 1 are protected from chemical spilling.

Consequently, the position of the first substrate holder 18 and the gas flow relative to the front side 3 of the substrate 1 needs to be adjusted such that only the active area on the front side 3 of the substrate 1 is protected.

During the bevel-etch-process, the first substrate holder 18 may preferably be in the open position to prevent pin- or finger marks being created within the edge exclusion zone 6. The first substrate holder 18 may rotate at the same or at a different rotation speed to the second substrate holder 19. Alternatively, the first substrate holder 18 may rotate at a time-dependent variable speed. Optionally, after finishing the bevel-etch-process, a short rinsing process may be carried out, e.g., with deionized (DI) water to clean the edge exclusion zone 6 from the chemical residues.

After the bevel-etch-process is finished, the first substrate holder 18 picks the substrate 1 up again by closing the fingers around the substrate 1 and lifts the substrate 1 off the second substrate holder 19 to bring the substrate 1 into a position for performing a backside-etch/clean-process within the treatment chamber 20 (see Figure 6) for etching and/or cleaning an area of the substrate 1, which was previously covered by the second substrate holder 19. In the position shown in Figure 6, the backside-etch/clean-process is carried out on the backside 5 of the substrate 1. The front side 3 of the substrate 1 is physically protected by the first substrate holder 18 being in the closed position holding the substrate 1 and the gas flow providing a gas curtain, while at least the second liquid dispensing element 24 dispenses a liquid, e.g., a chemical solution, onto the back side 5 of the substrate 1.

The process parameters, particularly, the rotational speed of the substrate 1, and therefore, of the first substrate holder 18, the position of at least the second liquid dispensing element 24, and the liquid dispensing rate, are selected or controlled by the control unit 22 to remove the material depositions and/or material layers 2 from the back side 5 of the substrate 1. After the backside-etch-process is finished, a final rinsing and drying process is carried out to remove any chemical residues from the substrate 1. Therefore, the liquid dispensing unit 21 may dispense a cleaning liquid onto the substrate 1 and the system 17 may further comprise a drying unit (not shown) configured to dry the substrate 1.

After that, the processing sequence is finished, and the first substrate holder 18 moves the substrate 1 out of the treatment chamber 20 to a position, where the robot arm (not shown) may pick up the processed substrate 1 for transporting the substrate 1 to the next station.

Variations of the processing sequence are possible. For example, in some processing sequences, an initial process may be carried out on the substrate 1, before the substrate 1 is moved inside the treatment chamber 20, e.g., the backside-etch-process. In some processing sequences, an appropriate rinsing process, e.g., with DI-water, may be carried out on the front side 3 of the substrate 1 before and after the first substrate holder 18 hands the substrate 1 over to the second substrate holder 19. Furthermore, in specific cases, any other sequences of handling and/or rinsing processes of the substrate 1 may be advantageous for achieving the required results. Further, the bevel-etch-process and the backside-etch-process may be performed sequentially, as exemplarily described above, or simultaneously.

Thus, the system 17 allows removing material depositions and/or material layers 2 from areas on the substrate 1, where the material depositions and/or material layers 2 do not fulfill any function and/or may be detrimental, while achieving a precise edge exclusion zone 6 only by adapting process parameters via software control, namely the control unit 22, to different surface treatment requirements, without the need of change hardware, such as equipment, tools and the like.

Figures 7a and 7b shows schematically and exemplarily lamella oscillations according to the disclosure, wherein Figure 7a shows a desired lamella formation and Figure 7b shows an undesired state of lamella breaking off.

Lamellas 27 are formed when a liquid is dispensed onto a rotating surface. Depending on the liquid flow rate and the at least one liquid flow dispensing position, that means, the position of a liquid dispensing unit relative to the rotating substrate 1, and the rotational speed of the substrate 1, a certain oscillation of the lamella formation and its disappearance can be observed. Further, it has been observed that an energy level of the surface of substrate 1, on which the liquid is applied, has a significant impact on the lamella formation and thus, on the selection of the process parameters for achieving the optimum results. An energy level of a surface has a significant influence on the hydrophilic or hydrophobic characteristic of the surface; this means that the energy level of the surface has an influence on the contact angle with which the liquid contacts the surface. The process parameters, which are influenced by the surface energy level, may be the liquid dispense or flow rate, the rotational speed of the surface, the movement of the liquid dispensing arm , and the like.

Figure 7a depicts a liquid lamella 27 formation, which supports the achievement of good process results, and Figure 7b shows the undesired state of a liquid lamella 27 breaking off or disappearing.

Figure 8 shows schematically and exemplarily a method 100 for a surface treatment of a substrate 1 with a liquid according to the disclosure. In a step S1, the first substrate holder 18 holding the substrate 1 is moved into the treatment chamber 20. In a step S2, the substrate 2 is handled over from the first substrate holder 18 to the second substrate holder 19. In a step S3, the substrate 1 being held by the second substrate holder 19 is rotated in and relative to the treatment chamber 20. In step S4, a liquid is dispensed onto the rotating substrate 1 by means of the liquid dispensing unit 21. The liquid dispensing unit 21 is at least partially movable relative to the second substrate holder 19. In a step S5, the method 100 further comprises controlling the rotational speed of the substrate 1, the position of the liquid dispensing unit 21 and/or the dispense rate of the liquid.

## Claims

1. A system (17) for a surface treatment of a substrate (1) with a liquid, comprising:
- a first substrate holder (18),
- a second substrate holder (19),
- a liquid dispensing unit (21),
- a treatment chamber (20), and
- a control unit (22),
wherein the first substrate holder (18) is configured to hold the substrate (1), wherein the first substrate holder (18) is moveable in the treatment chamber (20) and configured to hand the substrate (1) over to the second substrate holder (19), wherein the second substrate holder (19) is rotatable and configured to hold the substrate (1) during a rotation of the substrate (1) in and relative to the treatment chamber (20),
wherein the liquid dispensing unit (21) is moveable relative to the second substrate holder (19) and configured to dispense the liquid onto the substrate (1), and
wherein the control unit (22) is configured to control a rotational speed of the substrate (1), a position of the liquid dispensing unit (21) and/or a dispense rate of the liquid.

2. System (17) according to claim 1, wherein the control unit (22) is configured to control the rotational speed of the substrate (1), the position of the liquid dispensing unit (21) and/or the dispense rate of the liquid to provide lamella oscillations of the liquid dispensed onto the rotating substrate (1).

3. System (17) according to one of the preceding claims, wherein the control of the position of the liquid dispensing unit (21) is a control of an oscillating movement of at least a part of the liquid dispensing unit (21) between at least two position points.

4. System (17) according to one of the preceding claims, wherein the liquid dispensing unit (21) comprises at least one of a first liquid dispensing element (23) arranged at the first substrate holder (18), a second liquid dispensing element (24) arranged inside the second substrate holder (19), and a third liquid dispensing element (25) arranged at the second substrate holder (19).

5. System (17) according to one of the preceding claims, wherein the first substrate holder (18) comprises fingers, which are moveable into a closed position to hold the substrate (1) and into an open position to receive or release the substrate (1).

6. System (17) according to one of the preceding claims, wherein the first substrate holder (18) is configured to rotationally center the substrate (1) relative to the second substrate holder (19).

7. System (17) according to one of the preceding claims, wherein the second substrate holder (19) is a vacuum holder configured to hold the substrate (1) by means of suction.

8. System (17) according to one of the preceding claims, wherein the liquid dispensing unit (21) comprises at least a liquid dispensing arm.

9. System (17) according to one of the preceding claims, further comprising a drying unit to dry the substrate (1).

10. A method (100) for a surface treatment of a substrate (1) with a liquid, comprising:
- moving a first substrate holder (18) holding a substrate (1) in a treatment chamber (20),
- handling the substrate (1) over from the first substrate holder (18) to a rotatable second substrate holder (19),
- rotating the substrate (1) held by the second substrate holder (19) in and relative to the treatment chamber (20),
- dispensing a liquid onto the rotating substrate (1) by means of a liquid dispensing unit (21) which is moveable relative to the second substrate holder (19), and
- controlling a rotational speed of the substrate (1), a position of the liquid dispensing unit (21) and/or a dispense rate of the liquid.

11. Method (100) according to claim 10, wherein the rotational speed of the substrate (1), the position of the liquid dispensing unit (21) and/or the dispense rate of the liquid is controlled to provide lamella oscillations of the liquid dispensed onto the rotating substrate (1).

12. Method (100) according to one of the claims 10 or 11, wherein the liquid dispensing unit (21) comprises a first liquid dispensing element (23) arranged at the first substrate holder (18).

13. Method (100) according to one of the claims 10 to 12, further comprising:
- handling the substrate (1) back to the first substrate holder (18),
- dispensing liquid by means of the liquid dispensing unit (21) onto an area of the substrate (1) previously covered by the second substrate holder (19), and
- controlling a rotational speed of the substrate (1), a position of the liquid dispensing unit (21) and/or a dispense rate of the liquid.

14. Method (100) according to one of the claims 10 to 13, further comprising rotating of the substrate (1) held by the first substrate holder (18).

15. Method (100) according to one of the claims 10 to 14, wherein the liquid dispensing unit (21) comprises a second liquid dispensing element (24) arranged inside the second substrate holder (19).

16. Method (100) according to one of the claims 10 to 15, wherein the surface treatment is an etching and/or cleaning by means of an etching liquid and/or a cleaning liquid as the liquid dispensed onto the rotating substrate (1).

17. Method (100) according to one of the claims 10 to 16, further comprising a rinsing to rinse the substrate (1) and/or a drying to dry the substrate (1).

18. Method (100) according to one of the claims 10 to 17, wherein the substrate (1) comprises a front side (3) with a functional surface, a back side (5) opposite to the front side (3) and an edge (4) between the front side (3) and the back side (5), wherein the rotational speed of the substrate (1), the position of the liquid dispensing unit (21) and/or the dispense rate of the liquid is controlled to treat the edge (4) of the substrate (1), an edge exclusion zone (6) at the front side (3) of the substrate (1) and/or the back side (5) of the substrate (1).

19. Method (100) according to the preceding claim, wherein the liquid dispensing unit (21) comprises a third liquid dispensing element (25) arranged at the second substrate holder (19) and preferably arm-shaped.

20. Method (100) according to one of the claims 18 or 19, wherein the edge (4), the edge exclusion zone (6) and/or the back side (5) are treated simultaneously or sequentially.

21. Method (100) according to one of the claims 18 to 20, wherein the controlled position of the liquid dispensing unit (21) comprises a distance between the liquid dispensing unit (21) and the edge (4) of the substrate (1).

22. Method (100) according to one of the claims 18 to 21, wherein the rotational speed of the substrate (1), the position of the liquid dispensing unit (21) and/or the dispense rate of the liquid is controlled to treat the edge exclusion zone (6) in a width (ew) between 0.2 and 12 mm, preferably 0.5 to 9 mm.

23. Method (100) according to one of the one of the claims 10 to 22, further comprising a protection of an area not to be treated on the front side (3) of the substrate (1) by means of the first substrate holder (18) and/or a gas flow provided by the first liquid dispensing element (23).

24. Method (100) according to one of the claims 10 to 23, further comprising a rotational centering of the substrate (1) relative to the second substrate holder (19) by means of the first substrate holder (18).

25. Method (100) according to one of the claims 10 to 24, further comprising a rotation of the first substrate holder (18) during rotating the substrate (1) in the second substrate holder (19).

26. Method (100) according to one of the claims 10 to 25, wherein the handling of the substrate (1) between the first substrate holder (18) and the second substrate holder (19) is done at a rotational speed in a range of 0-700 rpm.

27. Method (100) according to one of the claims 10 to 26, wherein the orientation of the substrate (1) relative to the treatment chamber (20), preferably front side up, is maintained throughout the method (100) for surface treatment.

28. Method (100) according to one of the claims 11 to 27, wherein the control to provide lamella oscillations, in particular a software control, is the only adaption to different surface treatment requirements, in particular without tool change.

29. A computer program element for a system (17) for a surface treatment of a substrate (1) with a liquid, which, when being executed by a processing element, is adapted to perform the steps of one of the method claims 9 to 27.

## Amended claims

### Amended claims in accordance with Rule 137(2) EPC.

1. A system (17) for a surface treatment of a substrate (1) with a liquid, comprising:
- a first substrate holder (18),
- a second substrate holder (19),
- a liquid dispensing unit (21),
- a treatment chamber (20), and
- a control unit (22),
wherein the first substrate holder (18) is configured to hold the substrate (1), wherein the first substrate holder (18) is moveable in the treatment chamber (20) and configured to hand the substrate (1) over to the second substrate holder (19), wherein the second substrate holder (19) is rotatable and configured to hold the substrate (1) during a rotation of the substrate (1) in and relative to the treatment chamber (20),
wherein the liquid dispensing unit (21) is moveable relative to the second substrate holder (19) and configured to dispense the liquid onto the substrate (1), and
wherein the control unit (22) is configured to control a rotational speed of the substrate (1), a position of the liquid dispensing unit (21) and a dispense rate of the liquid.

2. System (17) according to claim 1, wherein the control unit (22) is configured to control the rotational speed of the substrate (1), the position of the liquid dispensing unit (21) and/or the dispense rate of the liquid to provide lamella oscillations of the liquid dispensed onto the rotating substrate (1).

3. System (17) according to one of the preceding claims, wherein the control of the position of the liquid dispensing unit (21) is a control of an oscillating movement of at least a part of the liquid dispensing unit (21) between at least two position points.

4. System (17) according to one of the preceding claims, wherein the liquid dispensing unit (21) comprises at least one of a first liquid dispensing element (23) arranged at the first substrate holder (18), a second liquid dispensing element (24) arranged inside the second substrate holder (19), and a third liquid dispensing element (25) arranged at the second substrate holder (19).

5. System (17) according to one of the preceding claims, wherein the first substrate holder (18) comprises fingers, which are moveable into a closed position to hold the substrate (1) and into an open position to receive or release the substrate (1).

6. System (17) according to one of the preceding claims, wherein the first substrate holder (18) is configured to rotationally center the substrate (1) relative to the second substrate holder (19).

7. System (17) according to one of the preceding claims, wherein the second substrate holder (19) is a vacuum holder configured to hold the substrate (1) by means of suction.

8. System (17) according to one of the preceding claims, wherein the liquid dispensing unit (21) comprises at least a liquid dispensing arm.

9. System (17) according to one of the preceding claims, further comprising a drying unit to dry the substrate (1).

10. A method (100) for a surface treatment of a substrate (1) with a liquid, comprising:
- moving a first substrate holder (18) holding a substrate (1) in a treatment chamber (20),
- handling the substrate (1) over from the first substrate holder (18) to a rotatable second substrate holder (19),
- rotating the substrate (1) held by the second substrate holder (19) in and relative to the treatment chamber (20),
- dispensing a liquid onto the rotating substrate (1) by means of a liquid dispensing unit (21) which is moveable relative to the second substrate holder (19), and
- controlling a rotational speed of the substrate (1), a position of the liquid dispensing unit (21) and a dispense rate of the liquid.

11. Method (100) according to claim 10, wherein the rotational speed of the substrate (1), the position of the liquid dispensing unit (21) and/or the dispense rate of the liquid is controlled to provide lamella oscillations of the liquid dispensed onto the rotating substrate (1).

12. Method (100) according to one of the claims 10 or 11, wherein the liquid dispensing unit (21) comprises a first liquid dispensing element (23) arranged at the first substrate holder (18).

13. Method (100) according to one of the claims 10 to 12, further comprising:
- handling the substrate (1) back to the first substrate holder (18),
- dispensing liquid by means of the liquid dispensing unit (21) onto an area of the substrate (1) previously covered by the second substrate holder (19), and
- controlling a rotational speed of the substrate (1), a position of the liquid dispensing unit (21) and/or a dispense rate of the liquid.

14. Method (100) according to one of the claims 10 to 13, further comprising rotating of the substrate (1) held by the first substrate holder (18).

15. Method (100) according to one of the claims 10 to 14, wherein the liquid dispensing unit (21) comprises a second liquid dispensing element (24) arranged inside the second substrate holder (19).

16. Method (100) according to one of the claims 10 to 15, wherein the surface treatment is an etching and/or cleaning by means of an etching liquid and/or a cleaning liquid as the liquid dispensed onto the rotating substrate (1).

17. Method (100) according to one of the claims 10 to 16, further comprising a rinsing to rinse the substrate (1) and/or a drying to dry the substrate (1).

18. Method (100) according to one of the claims 10 to 17, wherein the substrate (1) comprises a front side (3) with a functional surface, a back side (5) opposite to the front side (3) and an edge (4) between the front side (3) and the back side (5), wherein the rotational speed of the substrate (1), the position of the liquid dispensing unit (21) and/or the dispense rate of the liquid is controlled to treat the edge (4) of the substrate (1), an edge exclusion zone (6) at the front side (3) of the substrate (1) and/or the back side (5) of the substrate (1).

19. Method (100) according to the preceding claim, wherein the liquid dispensing unit (21) comprises a third liquid dispensing element (25) arranged at the second substrate holder (19) and preferably arm-shaped.

20. Method (100) according to one of the claims 18 or 19, wherein the edge (4), the edge exclusion zone (6) and/or the back side (5) are treated simultaneously or sequentially.

21. Method (100) according to one of the claims 18 to 20, wherein the controlled position of the liquid dispensing unit (21) comprises a distance between the liquid dispensing unit (21) and the edge (4) of the substrate (1).

22. Method (100) according to one of the claims 18 to 21, wherein the rotational speed of the substrate (1), the position of the liquid dispensing unit (21) and/or the dispense rate of the liquid is controlled to treat the edge exclusion zone (6) in a width (ew) between 0.2 and 12 mm, preferably 0.5 to 9 mm.

23. Method (100) according to one of the one of the claims 10 to 22, further comprising a protection of an area not to be treated on the front side (3) of the substrate (1) by means of the first substrate holder (18) and/or a gas flow provided by the first liquid dispensing element (23).

24. Method (100) according to one of the claims 10 to 23, further comprising a rotational centering of the substrate (1) relative to the second substrate holder (19) by means of the first substrate holder (18).

25. Method (100) according to one of the claims 10 to 24, further comprising a rotation of the first substrate holder (18) during rotating the substrate (1) in the second substrate holder (19).

26. Method (100) according to one of the claims 10 to 25, wherein the handling of the substrate (1) between the first substrate holder (18) and the second substrate holder (19) is done at a rotational speed in a range of 0-700 rpm.

27. Method (100) according to one of the claims 10 to 26, wherein the orientation of the substrate (1) relative to the treatment chamber (20), preferably front side up, is maintained throughout the method (100) for surface treatment.

28. Method (100) according to one of the claims 11 to 27, wherein the control to provide lamella oscillations, in particular a software control, is the only adaption to different surface treatment requirements, in particular without tool change.

29. A computer program element for a system (17) for a surface treatment of a substrate (1) with a liquid, which, when being executed by a processing element, is adapted to perform the steps of one of the method claims 10 to 28.
